# EUROPEAN PATENT APPLICATION

(11) **EP 3 185 308 A1**
(43) Date of publication of application: **28.06.2017**
(21) Application number: 16205687.3
(22) Date of filing: 21.12.2016
(51) Int. Cl.: H01L 31/0475, F21S 9/03, H01L 31/042

(54) **ARRAY OF UNEQUALLY SHAPED SOLAR PANELS**

(30) Priority: 21.12.2015 US 201514976113
(71) Applicant: Gama Sonic USA, Inc., Atlanta, GA 30350 (US)
(72) Inventor: Izardel, Lazar, 63322 Tel Aviv (IL)
(74) Representative: Jaeger, Michael David

(57) **Abstract**

A solar panel array (10) includes a plurality of sub-arrays (12) of solar panels (14). For each sub-array (12), the solar panels (14) are electrically connected in series, have unequal shapes, and have equal areas.

## Description

### FIELD OF THE INVENTION

The present invention relates generally to solar lighting and particularly to an array of unequally shaped solar panels and a light fixture therefor.

### BACKGROUND OF THE INVENTION

Various exterior lighting systems use photovoltaic panels (solar panels) powered by batteries. Sunlight impinges on the solar panel and charges the battery or batteries during the day time. The battery can subsequently provide a source of electricity for a lighting element during the nighttime. The battery is usually mounted in or about a fixed vertical pole.

A known problem that can occur with solar panels that degrades their lifetime is hot spots on the panel. Hot spots may damage the photovoltaic cell by overheating and may also lead to melting of solder joints, or creation of pin holes or open circuits in the cell. Hot spots may develop due to some cells being exposed to more or less sunlight than other cells, due to partial shading, dirt or bird droppings in a localized area, temperature variations across a panel, and non-uniform aging of the diffusion regions from cell to cell.

The destructive effects of hot-spot heating may be circumvented with a bypass diode. The bypass diode is connected in parallel, but with opposite polarity, to the solar cell. Under normal operation, each solar cell is forward biased and therefore the bypass diode is reverse biased and acts as an open circuit. However, if the solar cell is reverse biased due to a mismatch in short-circuit current between several series connected cells, then the bypass diode conducts, thereby allowing the current from the good solar cells to flow in the external circuit rather than forward biasing each good cell, thus limiting the current and preventing hot-spot heating.

### SUMMARY OF THE INVENTION

The present invention seeks to provide an array of unequally shaped solar panels, as is described more in detail hereinbelow. In the present invention, although the solar panels have unequal shapes, the areas of all solar panels connected in series are equal. This avoids unequal current flow through the panels and helps prevent hot spots. A light fixture is also provided which is powered by the electricity generated by the solar panels.

The present invention enables making an efficient solar panel in any shape, such as but not limited to, curved, concave, any other geometric shape.

One of the advantages of the invention is maximization of the solar panel power for a given surface/area, which is not necessarily square, by using different solar panels with unequal shapes but equal areas. The invention can be used to create solar powered lights without a need for a remote solar panel; the solar panel is sufficient to operate the light. The invention enables developing products that follow the market trend in terms of design, and yet still provide a maximum area solar panel that uses most of the available surface on the light fixture.

There is provided in accordance with an embodiment of the invention a solar panel array including a plurality of sub-arrays of solar panels, wherein for each of the sub-arrays, the solar panels are electrically connected in series, have unequal shapes, and have equal areas.

There is provided in accordance with an embodiment of the invention a light fixture including one or more batteries and one or more lights powered by the solar panel array.

### BRIEF DESCRIPTION OF THE DRAWINGS

The present invention will be understood and appreciated more fully from the following detailed description taken in conjunction with the drawings in which:
Fig. 1 is a simplified pictorial illustration of a solar panel array, constructed and operative in accordance with an embodiment of the present invention;
Fig. 2 is a simplified pictorial illustration of a solar panel array, constructed and operative in accordance with another embodiment of the present invention; and
Fig. 3 is a simplified pictorial illustration of a light fixture powered by any of the solar panel arrays of the invention, in accordance with an embodiment of the present invention.

### DETAILED DESCRIPTION OF EMBODIMENTS

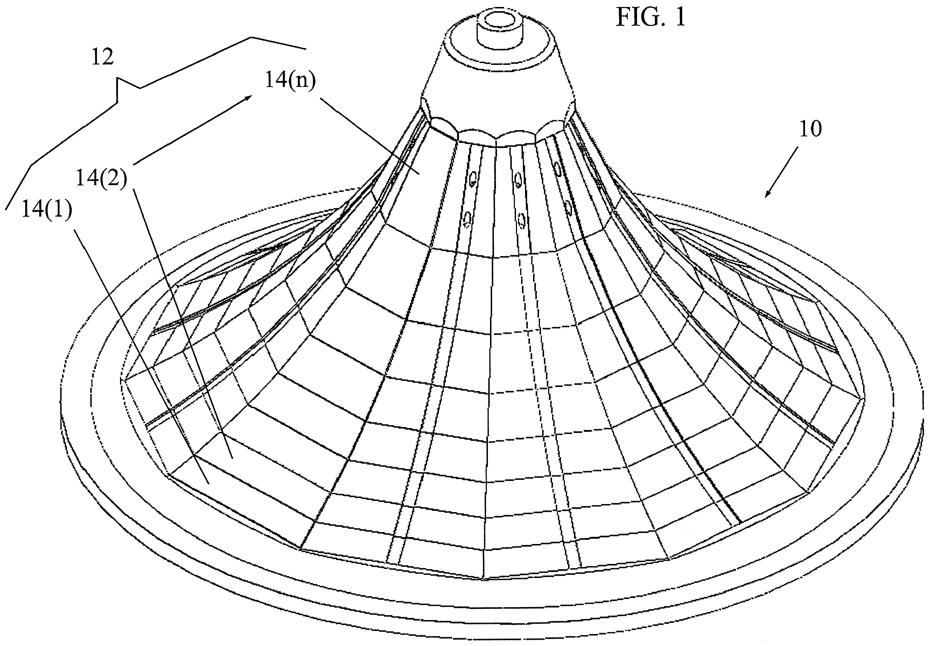

Reference is now made to Fig. 1, which illustrates a solar panel array 10, constructed and operative in accordance with a non-limiting embodiment of the present invention.

The solar panel array 10 includes a plurality of *m* sub-arrays 12 of solar panels 14, or as shown in the drawing, *n* solar panels 14(*l*) up to 14(*n*). In each sub-array 12, the solar panels 14 are electrically connected in series. In the illustrated embodiment, each sub-array 12 is curved (e.g., concave), but the invention is not limited to this shape, and the sub-arrays can be convex or any other regular or irregular shape, curved or not curved. The sub-arrays 12 may be electrically connected to one another in parallel or serial according to the battery charging requirement.

The solar panels 14 are any kind of photovoltaic cell for generating electricity from solar energy, such as but not limited to, monocrystalline, polycrystalline or amorphous film cells.

For each sub-array 12 of solar panels 14, the solar panels 14 have unequal shapes, but the areas of all solar panels 14 are equal. In other words, the area of solar panel 14(*l*) = the area of solar panel 14(2) = the area of solar panel 14(*3*) =... = the area of solar panel 14(*n*). For example, the length of the lowest solar panel 14(1) is longer than the length of solar panel 14(2), but the width of the lowest solar panel 14(1) is less than the width of solar panel 14(2) so that the areas are the same. The uppermost solar panel 14(n) has the smallest length and largest width (length being the horizontal dimension and width being the vertical dimension).

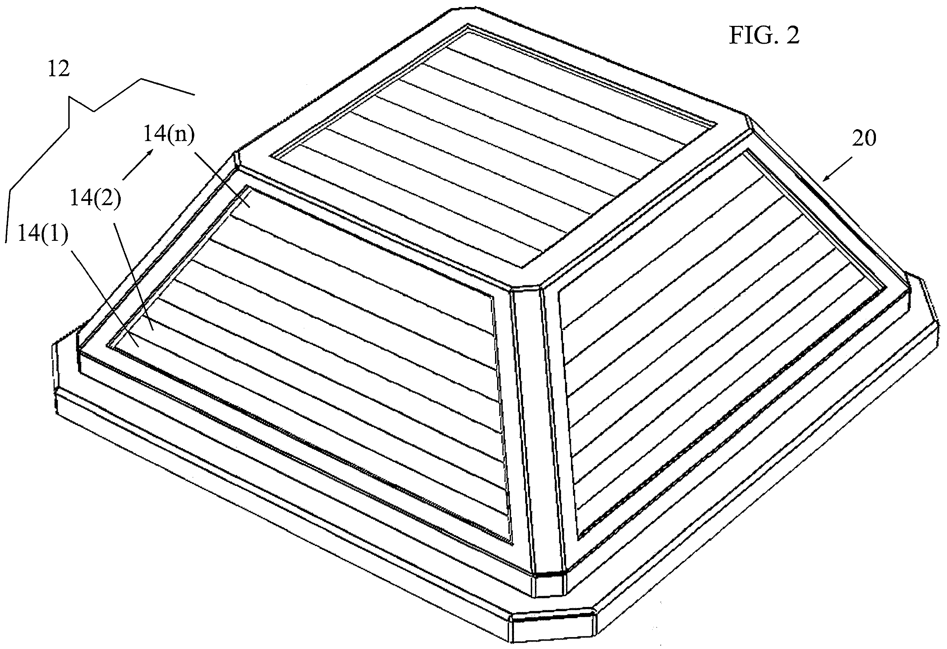

Reference is now made to Fig. 2, which illustrates a solar panel array 20, constructed and operative in accordance with another non-limiting embodiment of the present invention.

Similar to the embodiment of Fig. 1, solar panel array 20 includes a plurality of sub-arrays 22 of solar panels 24, *n* solar panels 24(*l*) up to 24(*n*). In each sub-array 22, the solar panels 24 are electrically connected in series. In the illustrated embodiment, each sub-array 12 is flat, but could be other shapes. The sub-arrays 22 may be electrically connected to one another in parallel.

For each sub-array 22 of solar panels 24, the solar panels 24 have unequal shapes, but the areas of all solar panels 24 are equal. The uppermost solar panel 24(n) has the smallest length and largest width (length being the horizontal dimension and width being the vertical dimension). In the top horizontal array, all solar panels have equal shapes and areas.

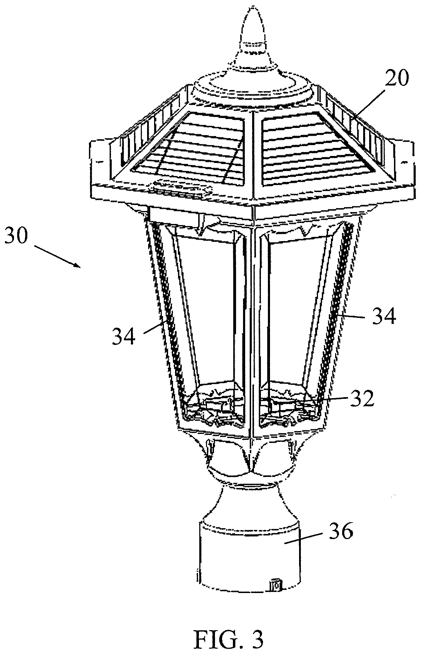

Reference is now made to Fig. 3, which illustrates a light fixture 30 powered by solar panel array 20 (but could alternatively by powered by solar panel array 10), constructed and operative in accordance with a non-limiting embodiment of the present invention.

The solar panel array 20 is mounted at the top of the light fixture 30 and generates electricity which is stored in one or more batteries 32, which are in electrical communication with solar panel array 20. The one or more batteries 32 power one or more lights 34 (such as, but not limited to, LED lights). The batteries 32 may be located at the bottom of the fixture 30 or at any other convenient location. The lights 34 may be located along sides of the fixture 30 or at any other convenient location. The light fixture 30 may be mounted on a pole or mounting bracket 36.

## Claims

1. A solar energy device comprising:
a solar panel array comprising a plurality of sub-arrays of solar panels, wherein for each of said sub-arrays, said solar panels are electrically connected in series, have unequal shapes, and have equal areas.

2. The solar energy device according to claim 1, wherein said sub-arrays are electrically connected to one another in parallel.

3. The solar energy device according to claim 1, wherein each of said sub-arrays is curved.

4. The solar energy device according to claim 1, wherein each of said sub-arrays is concave.

5. The solar energy device according to claim 1, wherein each of said sub-arrays comprises a lowermost solar panel and an uppermost solar panel, and said lowermost solar panel has the largest length and smallest width and said uppermost solar panel has the smallest length and largest width of said solar panels.

6. The solar energy device according to claim 1, further comprising a light fixture comprising one or more batteries and one or more lights powered by said solar panel array.
